(19) **Europäisches Patentamt / European Patent Office / Office européen des brevets**

(11) **EP 1 148 513 B1**

(12) **EUROPÄISCHE PATENTSCHRIFT**

(45) Veröffentlichungstag und Bekanntmachung des Hinweises auf die Patenterteilung:
**14.05.2008   Patentblatt 2008/20**

(51) Int Cl.:
*G11C 11/22* $^{(2006.01)}$

(21) Anmeldenummer: **01107397.0**

(22) Anmeldetag: **26.03.2001**

(54) **Verfahren zum Betrieb einer ferroelektrischen Speicheranordnung**

Operation method for ferroelectric memory

Méthode d' utilsation d'une mémoire ferroélectrique

(84) Benannte Vertragsstaaten:
**DE FR GB IE IT**

(30) Priorität: **04.04.2000   DE 10016726**

(43) Veröffentlichungstag der Anmeldung:
**24.10.2001   Patentblatt 2001/43**

(73) Patentinhaber: **Infineon Technologies AG**
**81669 München (DE)**

(72) Erfinder:
 • **Hönigschmid, Heinz**
   **East Fishkill, NY 12524 (US)**
 • **Roehr, Thomas, Dr.**
   **85609 Aschheim (DE)**

(74) Vertreter: **Müller - Hoffmann & Partner Patentanwälte,**
**Innere Wiener Strasse 17**
**81667 München (DE)**

(56) Entgegenhaltungen:
**DE-A- 19 724 449      DE-A- 19 832 991**
**DE-A- 19 832 994      US-A- 5 121 353**
**US-A- 5 959 878**

EP 1 148 513 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Betrieb einer ferroelektrischen Speicheranordnung im $V_{DD}/2$-Modus gemäß dem Oberbegriff des Patentanspruchs 1.

Ein derartiges Verfahren ist aus US-A-5,959,878 bekannt.

Allgemein besteht bei ferroelektrischen Speichern, die als integrierte Schaltungen implementiert sind, die Gefahr, dass durch parasitäre Bauelemente Spannungsdifferenzen an den Elektroden von ferroelektrischen Speicherkondensatoren auftreten. Je nach Polarisation des Dielektrikums des Speicherkondensators und nach Polarität der Spannungsdifferenzen verstärken diese die Polarisation des Dielektrikums oder schwächen sie.

Im schlimmsten Fall kann es somit beim Lesen der Speicheranordnung zu einer Fehlbewertung der Information kommen, was einem Datenverlust entspricht.

Bei einer bekannten in DE 198 32 994 (SIEMENS AG) beschriebenen Speicheranordnung wird mit dem Kurzschlusstransistor, der parallel zum Speicherkondensator in jeder Speicherzelle vorgesehen ist, der Speicherknoten mit der oberen oder Topelektrodenplatte des Speicherkondensators verbunden und damit der Junction-Leckstrom des Speicherknotens ausgeglichen.

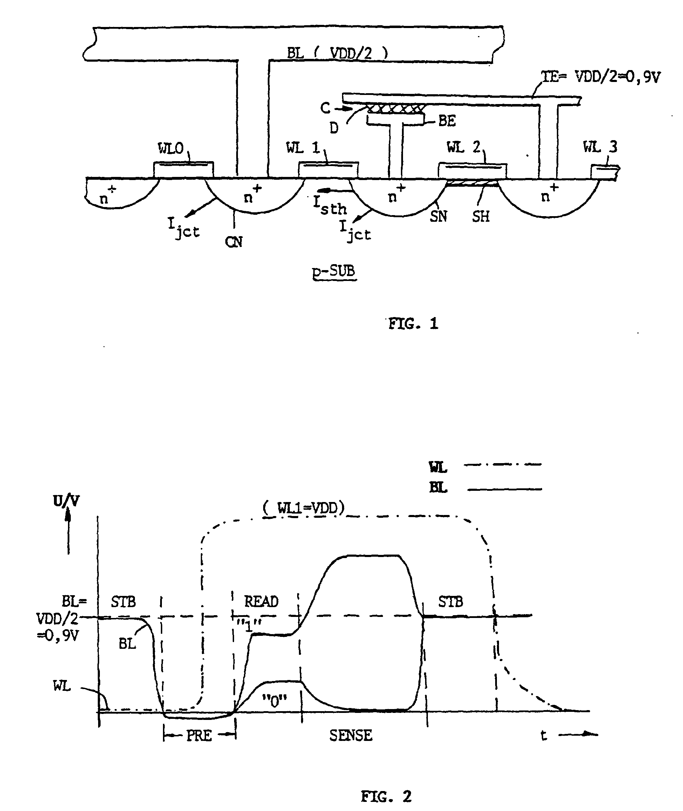

Die beiliegende Fig. 1 zeigt schematisch eine Schnittdarstellung durch eine mit einem solchen Kurzschlusstransistor ausgestattete bekannte Speicherzelle einer ferroelektrischen Speicheranordnung. Es ist deutlich, dass bei dieser beispielhaften Speicherzelle der Speicherkondensator C unter der Bit leitung BL gelegen ist. Der Speicherkondensator C weist eine obere Platte oder Topelektrode TE und eine untere Platte oder Bottomelektrode BE auf. Zwischen der oberen Platte TE und der unteren Platte BE des Speicherkondensators C befindet sich ein ferroelektrisches Dielektrikum D, beispielsweise aus PZT (Bleizirkoniumtitanat). In einem Halbleiterkörper, der z.B. ein P-Substrat ist, sind $n^+$-leitende Zonen eindiffundiert, und über dem Substrat liegen zwischen den $n^+$-leitenden Zonen Wortleitungen WL0, WL1, WL2, WL3, usw., die in der Schnittdarstellung der Fig. 1 senkrecht zur Papierebene verlaufen. Zwischen benachbarten Wortleitungen in Fig. 1 zwischen WL0 und WL1; WL2 und WL3 bilden $n^+$-leitenden Zonen Common Nodes CN.

Ein Kurzschlusstransistor SH, der z.B. ein Feldeffekttransistor vom Verarmungstyp ist, liegt unter der Wortleitung WL2 zwischen dem Speicherknoten SN, der mit der unteren Kondensatorelektrode BE verbunden ist und dem benachbarten $n^+$-Bereich, der mit der oberen Kondensatorelektrode BE verbunden ist. Bei Vorliegen eines entsprechenden Ansteuersignals verbindet der Kurzschlusstransistor SH die obere Kondensatorelektrode TE mit der unteren Kondensatorelektrode BE, d.h. er schließt die beiden Elektroden kurz. Über die gesamte Speicheranordnung betrachtet, kann ein Kurzschluss sämtlicher Speicherkondensator C den gesamten Junction-Leckstrom $I_{jct}$ kompensieren.

Fig. 2 erläutert in Form eines Signal-Zeitdiagramms das in der obigen Druckschrift vorgeschlagene Verfahren für den $V_{DD}/2$-Betrieb der ferroelektrischen Speicheranordnung mit Ausgleich des Junction-Leckstroms $I_{jct}$ jedes Speicherknotens SN.

Beim Einschalten der Speicheranordnung befinden sich alle Wortleitungen WL auf Null Volt. Zuerst wird sodann in einer Phase STB eine allen Speicherkondensatoren C gemeinsame Elektrode, die mit TE des Kondensators C verbindbar oder verbunden ist, auf die Spannung $V_{DD}/2$ hochgefahren, z.B. auf 0,9 Volt. Da nun die Einsatzspannung der Kurzschlusstransistoren SH entsprechend stark negativ gewählt ist, leiten diese Kurzschlusstransistoren SH auch dann noch, wenn die allen Speicherkondensatoren C gemeinsame Elektrode auf $V_{DD}/2$ aufgeladen wurde. Somit sind während der Anfangsphase STB die beiden Elektroden sämtlicher ferroelektrischer Speicherkondensatoren C kurzgeschlossen. Dabei findet der erwähnte Ausgleich der Junction-Leckströme $I_{jct}$ statt. Bei einer herkömmlichen 4-M-Speicheranordnung fließt dabei ein Stand-by-Strom von

$$I_{stb1} = 2^{22} \cdot I_{jct} + 2^{21} \cdot I_{jct}$$

In Gleichung (1) ist der erste Term bedingt durch die Speicherknoten SN und der zweite Term durch die Common Nodes CN.

Setzt man typische Werte der 256-MDRAM-Technologie voraus ($I_{jct}$ = 20fA), so erhält man für den Stand-by, so erhält man für den Stand-by-Strom

$$I_{stb1} = 125 \ nA.$$

Dieser den Speicherkondensator C kurzschließenden Phase STB folgt ein Prechargeschritt PRE, indem zunächst alle anzusprechenden BL auf Null Volt gelegt werden und die Auswahltransistoren gesperrt sind. Nach dem Prechargeschritt PRE erfolgt ein Zugriff zu gewählten Speicherzellen, z.B. zu dem in Fig. 1 dargestellten Speicherknoten SN. Dadurch, dass die entsprechende Wortleitung WL, also im Beispiel der Fig. 1 die Wortleitung WL1, von Null Volt auf die volle Versorgungsspannung $V_{DD}$ oder höher aufgeladen wird, werden die gewünschten ferroelektrischen Speicherkondensatoren C mit den entsprechenden Bitleitungen verbunden. Dadurch, dass die angesprochenen BL durch den Prechargeschritt PRE auf OV vorgeladen sind, kann ein Verschiebestrom durch den Ferrokondensator C fließen und ein Ladungsausgleich zwischen den selektierten ferroelektrischen Speicherkondensatoren und den zugehörigen Bitleitungen erfolgen. Dieser Schritt ist in Fig. 2 durch den Sachritt READ symbolisiert. Bevor dies aber geschieht, müssen die Gates der Kurzschlusstransistoren, die die selektierten ferroelektrischen Speicherkondensatoren C kurzschließen, abgeschaltet werden. Dies geschieht durch ein negatives Potential an der im Kurzschlusstransistor SH entsprechenden Wortleitung, also im Beispiel der Fig. 1 an der Wortleitung WL2. Durch dieses negative Potenzial werden lediglich die gewünschten Feldeffekttransistoren vom Verarmungstyp abgeschaltet. Feldeffekttransistoren vom Anreichungstyp, die ebenfalls mit der Wortleitung WL2 verbunden sind, waren bereits durch das Bereitschaftspotenzial im Preschritt abgeschaltet und werden durch das negative Potenzial nur noch hochohmiger gemacht.

Nach Bewerten des Lesesignals READ und dessen Verstärkung im Schritt SENSE wird die selektierte Wortleitung, also beispielsweise WL1, wieder auf Null Volt entladen, was die selektierten Speicherzellen wieder von den Bitleitungen BL abtrennt. Um den Kurzschluss der Elektroden des ferroelektrischen Speicherkondensators C wieder herzustellen, wird durch Entladen der dem Kurzschlusstransistor SH entsprechenden Wortleitung WL2 auf Null Volt der Kurzschlusstransistor SH eingeschaltet. Schließlich wird dann die Wortleitung WL1 auf Null Volt entladen, um die selektierten Speicherzellen wieder von den Bitleitungen BL zu trennen. Fig. 1 zeigt, dass außer dem Leckstrom $I_{jct}$ auch ein Subthreshold-Leckstrom $I_{sth}$ in der Precharge-Phase PRE fließt, der jedoch geringer ist als der Junction-Leckstrom $I_{jct}$.

Bei einer in der eingangs erwähnten Druckschrift US-A-5,959,878 beschriebenen ferroelektrischen Speicheranordnung sind gemäß der dortigen Fig. 6 die Kurzschlusstransistoren durch ein über eine eigene Ansteuerleitung zugeführtes Stand-by-Schaltsignal mit der Amplitude der Betriebsspannung durchschaltbar, um die beiden Elektroden der Speicherkondensatoren in der Stand-by-Phase kurzzuschließen (vgl. Fig. 6 sowie Fig. 9 und die dazugehörige Beschreibung in Spalte 10, Zeile 62 bis Spalte 11, Zeile 45 sowie Spalte 13, Zeile 37 bis Spalte 14, Zeile 16). Die in Spalte 14 dieser Druckschrift deutlich beschriebene Aufeinanderfolge zuerst der Precharge-Phase und dann der Stand-by-Phase ist in Fig. 9 nicht deutlich hervorgehoben. Beim Vergleich der ersten Zeile mit der dritten Zeile dieses Signalzeitdiagramms scheint es als ob Stand-by-Phase und Precharge-Phase zusammenfallen würden. Nach der in Spalte 14 enthaltenen Beschreibung ist es aber so, dass die Precharge-Phase, bei der das Potenzial der Bitleitung zu Null Volt gemacht wird, mit dem Abfallen des Potenzials an der Wortleitung beginnt, d.h. in dem Moment, wo das Potenzial an der Bitleitung abzufallen beginnt, und dann erst beginnt die Stand-by-Phase, die das Potenzial an der Plateleitung und an der einen Elektrode der ferroelektrischen Kapazität liegenden Knotens ausgleicht, d.h. auf $V_{CC}/2$ bringt.

Es ist Aufgabe der Erfindung, ein Verfahren anzugeben, durch das der im Stand-by einer ferroelektrischen Speicheranordnung fließende Gesamt-Stand-by-Strom reduziert werden kann.

Das Prinzip des durch die Erfindung vorgeschlagenen Verfahrens liegt darin, bei einem ferroelektrischen im $V_{DD}/2$-Betrieb betriebenen Speicher, der bereits eine Leckstromkompensation mittels des geschilderten Kurzschlusstransistors enthält, diesen auch zur Kompensation des Subthreshold-Leckstroms $I_{sth}$ zu verwenden.

Ein die obige Aufgabe lösendes Verfahren zum Betrieb einer ferroelektrischen Speicheranordnung im $V_{DD}/2$-Modus, bei dem die an einer allen Speicherzellen gemeinsamen Elektrodenleitung angelegte Spannung annähernd gleich der halben Versorgungsspannung $V_{DD}$ ist, wobei die Speicheranordnung eine Vielzahl von Speicherzellen aufweist, die jeweils mindestens einen Auswahltransistor, einen Speicherkondensator mit einer oberen und unteren Elektrode und einen mit seiner Source-Drain-Strecke parallel zum Speicherkondensator geschalteten Kurzschlusstransistor aufweisen, der nach einem Lese- oder Schreibvorgang, bei dem die Speicherzellen über jeweils zugeordnete Wortleitungen und über jeweils zugeordnete, in einer Precharge-Phase vorgeladene Bitleitungen angesteuert werden, während einer Stand-by-Phase angesteuert wird und dabei die Elektroden des Speicherkondensators kurzschließt, wobei die obere Elektrode aller ferroelektrischen Speicherkondensatoren mit einer gemeinsamen Elektrodenleitung verbunden wird, ist dadurch gekennzeichnet, dass die Einsatzspannung der Kurzschlusstransistoren so negativ gewählt wird, dass der die Stand-by-Phase steuernde Kurzschluss der beiden Elektroden der Speicherkondensatoren durch Hochfahren der Spannung an der gemeinsamen Elektrodenleitung auf die halbe Versorgungsspannung bewirkt wird, und dass die Stand-by-Phase zeitlich mit der Precharge-Phase zusammenfällt und dabei die Bitleitungen ein anderes Potenzial als die beiden Elektroden des Speicherkondensators aufweisen.

In vorteilhafter Weiterbildung dieses Verfahrens wird nach der Auswahl von Speicherzellen die Ansteuerphase der entsprechenden Kurzschlusstransistoren dieser ausgewählten Speicherzellen durch eine negatives Potenzial an der entsprechenden Wortleitung jedes Kurzschlusstransistors beendet.

Bei einer weiteren vorteilhaften Weiterbildung dieses Verfahrens wird zum Wiederherstellen des Kurzschlusses der Elektroden des ferroelektrischen Speicherkondensators mit den selektierten Speicherzellen die Wortleitung, die mit dem entsprechenden Kurzschlusstransistor verbunden ist, wieder auf Null Volt entladen.

Vorteilhafter Weise sind bei der mit diesem Verfahren betriebenen Speicheranordnung alle Kurzschlusstransistoren an Source und Drain jeweils mit einer gemeinsamen Elektrode verbindbar.

Besonders vorteilhaft lässt sich dieses Verfahren bei einer entsprechend eingerichteten ferroelektrischen Speicheranordnung anwenden.

Da dadurch die herkömmlich zur Kompensation dienende STB-Phase im zeitlichen Ablauf vermieden wird, kann außer der Verringerung des Gesamt-Stand-by-Stroms (um 30 % bei einer 4-M-Speicheranordnung) auch die Betriebsgeschwindigkeit der Speicheranordnung erhöht werden.

Sinngemäß kann das erfindungsgemäße Verfahren auch bei andersartigen Speichern, die eine Hysteresekennlinie haben, angewendet werden.

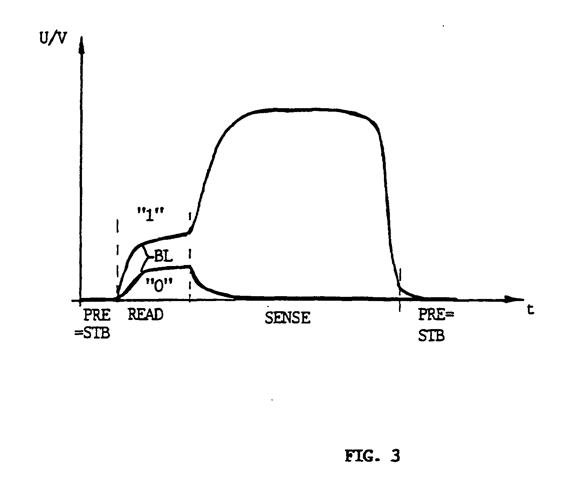

Das erfindungsgemäße Verfahren wird nachstehend bezogen auf ein in Fig. 3 dargestelltes Signalzeitdiagramm erläutert, welches das neue erfindungsgemäße Timing veranschaulicht. Gemäß Fig. 3 wird der Schritt STB, in dem die ferroelektrischen Speicherkondensatoren durch die Kurzschlusstransistoren kurzgeschlossen werden, zeitlich mit dem Precharge-Schritt PRE zusammengelegt, wobei dabei die Bitleitungen BL ein anderes Potenzial als die obere und untere Elektrode TE und BE des Speicherkondensators C aufweisen. Dadurch entfällt der separate Stand-by-Schritt STB. Die weiteren zeitlichen Abläufe während eines Ansteuerzyklus einer Speicherzelle können mit denen des Standes der Technik, wie sie oben anhand der Fig. 1 und 2 erläutert wurden, identisch sein.

Es ist zu erwähnen, dass die Struktur des Speicherarrays einer ferroelektrischen Speicheranordnung, bei der das erfindungsgemäße Verfahren durchführbar ist, dieselbe sein kann, wie sie in der eingangs erwähnten Druckschrift offenbart ist, und dass nur ein Steuerinterface für die Ausführung des erfindungsgemäßen Timings angepasst sein muss.

Während des mit dem Prechargeschritt zeitlich zusammenfallenden STB-Schritts fließt ein Subthreshold-Strom $I_{sth}$ durch jeden gesperrten Auswahl- oder Array-Transistor, dennoch wird der gesamte Stand-by-Strom verringert, da $I_{sth}$ viel kleiner als $I_{jct}$ ist, bei einer beispielhaft angenommenen 4-M-Speicheranordnung um 30 %.

Die Zugriffszeit wird um die Zeitdauer der STB-Phase gemäß Fig. 2 verringert. Die nachstehende Gleichung (2) gibt den durch das erfindungsgemäße Verfahren ermöglichten Gesamt-Stand-by-Strom an

$$I_{stb2} = 2^{22} \cdot I_{jct} + 2^{22} \cdot I_{sth.}$$

Setzt man auch hier typische Werte der 256-MDRAM-Technologie voraus, so erhält man für den Gesamt-Standy-by-Strom

$$I_{stb2} = 85 \text{ nA.}$$

## Patentansprüche

1. Verfahren zum Betrieb einer ferroelektrischen Speicheranordnung im $V_{DD}/2$-Modus, bei dem die an einer allen Speicherzellen gemeinsamen Elektrodenleitung angelegte Spannung annähernd gleich der halben Versorgungsspannung $V_{DD}$ ist, wobei die Speicheranordnung eine Vielzahl von Speicherzellen aufweist, die jeweils mindestens einen Auswahltransistor, einen Speicherkondensator (C) mit einer oberen und unteren Elektrode (BE, TE) und einen mit seiner Source-Drain-Strecke parallel zum Speicherkondensator (C) geschalteten Kurzschlusstransistor (SH) aufweisen, der nach einem Lese- oder Schreibvorgang, bei dem die Speicherzellen über jeweils zugeordnete Wortleitungen (WL0, WL1, ...) und über jeweils zugeordnete, in einer Precharge-Phase (PRE) vorgeladene Bitleitungen (BL) angesteuert werden, während einer Stand-by-Phase (STB) angesteuert wird und dabei die Elektroden (BE, TE) des Speicherkondensators (C) kurzschließt, wobei die obere Elektrode (TE) aller ferroelektrischen Speicherkondensatoren (C) mit der gemeinsamen Elektrodenleitung verbunden wird,
**dadurch gekennzeichnet, dass**
die Einsatzspannung der Kurzschlusstransistoren (SH) so negativ gewählt wird, dass der die Stand-by-Phase (STB) steuernde Kurzschluss der beiden Elektroden (BE, TE) der Speicherkondensatoren durch Hochfahren der Spannung an der gemeinsamen Elektrodenleitung auf die halbe Versorgungsspannung ($V_{DD}$) bewirkt wird, und dass
die Stand-by-Phase (STB) zeitlich mit der Precharge-Phase (PRE) zusammenfällt und dabei die Bitleitungen (BL) ein anderes Potenzial als die beiden Elektroden (BE, TE) des Speicherkondensators aufweisen.

2. Verfahren zum Betrieb einer ferroelektrischen Speicheranordnung nach Anspruch 1,
**dadurch gekennzeichnet, dass**
nach der Auswahl von Speicherzellen die Ansteuerphase der entsprechenden Kurzschlusstransistoren (SH) dieser ausgewählten Speicherzellen durch ein negatives Potenzial an der entsprechenden Wortleitung jedes Kurzschlusstransistors (SH) (z.B. WL2) beendet wird.

3. Verfahren zum Betrieb einer ferroelektrischen Speicheranordnung nach Anspruch 1,
**dadurch gekennzeichnet, dass**
zum Wiederherstellen des Kurzschlusses der Elektroden (BE, TE) des ferroelektrischen Speicherkondensators (C) mit den selektierten Speicherzellen die Wortleitung (WL2), die mit dem entsprechenden Kurzschlusstransistor (SH) verbunden ist, wieder auf Null Volt entladen wird.

4. Verfahren zum Betrieb einer ferroelektrischen Speicheranordnung nach einem der vorangehenden Ansprüche,
**dadurch gekennzeichnet, dass**
alle Kurzschlusstransistoren (SH) an Source und Drain jeweils mit einer gemeinsamen Elektrode verbindbar sind.

5. Ferroelektrische Speicheranordnung, die zur Anwendung des Verfahrens nach einem der Ansprüche 1 bis 4 eingerichtet ist.

## Claims

1. Method for operation of a ferroelectric memory arrangement in the $V_{DD}/2$ mode, in which the voltage which is applied to an electrode line which is common to all the memory cells is approximately equal to half the supply voltage $V_{DD}$, with the memory arrangement having a large number of memory cells which each have at least one selection transistor, one storage capacitor (C) with an upper and a lower electrode (BE, TE) and one short-circuiting transistor (SH) whose source-drain junction is connected in parallel with the storage capacitor (C) and which, after a read or write procedure in which the memory cells are driven via respectively associated word lines (WL0, WL1, ...) and via respectively associated bit lines (BL), which are precharged in a precharge phase (PRE), is driven during a standby phase (STB) and in the process short-circuits the electrodes (BE, TE) in the storage capacitor (C), with the upper electrode (TE) of all the ferroelectric storage capacitors (C) being connected to the common electrode line, **characterized in that** the threshold voltage of the short-circuiting transistors (SH) is chosen to be sufficiently negative that the short circuit, which controls the standby phase (STB), of the two electrodes (BE, TE) of the storage capacitors is produced by raising the voltage on the common electrode line to half the supply voltage ($V_{DD}$), and **in that** the standby phase (STB) coincides with the precharge phase (PRE) in time and, in the process, the bit lines (BL) are at a different potential to that of the two electrodes (BE, TE) of the storage capacitor.

2. Method for operation of a ferroelectric memory arrangement according to Claim 1, **characterized in that**, after the selection of the memory cells, the actuation phase of the corresponding short-circuiting transistors (SH) of these selected memory cells is ended by a negative potential applied to the corresponding word line of each short-circuiting transistor (SH) (e.g. WL2).

3. Method for operation of a ferroelectric memory arrangement according to Claim 1, **characterized in that**, in order to reproduce the short-circuit of the electrodes (BE, TE) of the ferroelectric storage capacitor (C) to the selected memory cells, the word line (WL2) which is connected to the corresponding short-circuiting transistor (SH) is discharged to zero volts once again.

4. The method for operation of a ferroelectric memory arrangement according to one of the preceding claims, **characterized in that** the source and drain of each of all short-circuiting transistors (SH) can be connected to a common electrode.

5. Ferroelectric memory arrangement, which is designed to use the method according to one of Claims 1 to 4.

## Revendications

1. Procédé pour faire fonctionner une mémoire ferroélectrique en mode $V_{DD}/2$, dans lequel la tension appliquée à une ligne d'électrodes commune à toutes les cellules de mémoire est à peu près égale à la moitié de la tension $V_{DD}$ d'alimentation, la mémoire ayant une pluralité de cellules de mémoire qui ont respectivement au moins un transistor de sélection, un condensateur (C) d'accumulation ayant une électrode (BE) supérieure et une électrode (TE) inférieure, et un transistor (SH) de court-circuit monté par sa section de source-drain en parallèle au condensateur (C) d'accumulation, transistor de court-circuit qui, après une opération de lecture ou d'écriture, dans laquelle les cellules de mémoire sont commandées par des lignes (WL0, WL1, ...) de mots respectivement associées et par des lignes (BL) de bits respectivement associées et préchargées dans une phase (BRE) de précharge, tandis que pendant une phase (STB) de stand-by, il est commandé et court-circuite les électrodes (BE, TE) du condensateur (C) d'accumulation, l'électrode (TE) supérieure de tous les condensateurs (C) d'accumulation ferroélectriques étant reliée à la ligne d'électrodes commune, **caractérisé en ce que** on choisit la tension de coupure des transistors (SH) de court-circuit d'une façon si négative que le court-circuit des deux électrodes (BE, TE) des condensateurs d'accumulation, commandé par la phase (STB) de stand-by, est provoqué par l'élévation de la tension de la ligne d'électrodes commune à la moitié de la tension ($V_{DD}$) d'alimentation, et **en ce que** la phase (STB) de stand-by coïncide dans le temps avec la phase (PRE) de précharge, et ainsi les lignes (BL) de bits ont un potentiel autre que les deux électrodes (BE, TE) du condensateur d'accumulation.

2. Procédé pour faire fonctionner une mémoire ferroélectrique suivant la revendication 1,

**caractérisé en ce que**
après la sélection de cellules de mémoire, on met fin à la phase de commande des transistors (SH) de court-circuit correspondants de ces cellules de mémoire sélectionnées, par application d'un potentiel négatif à la ligne de mots correspondante de chaque transistor (SH) de court-circuit (par exemple WL2).

3. Procédé pour faire fonctionner une mémoire ferroélectrique suivant la revendication 1,
   **caractérisé en ce que**
   pour rétablir le court-circuit des électrodes (BE, TE) du condensateur (C) d'accumulation ferroélectrique avec les cellules de mémoire sélectionnées, on redécharge jusqu'à zéro volt la ligne (WL2) de mots, qui est reliée au transistor (SH) de court-circuit correspondant.

4. Procédé pour faire fonctionner une mémoire ferroélectrique suivant l'une des revendications précédentes,
   **caractérisé en ce que**
   tous les transistors (SH) de court-circuit peuvent être reliés par la source et le drain respectivement à une électrode commune.

5. Mémoire ferroélectrique qui est conçue pour l'utilisation du procédé suivant l'une des revendications 1 à 4.

FIG. 1

FIG. 2

U/V

"1"

BL

"0"

PRE
=STB

READ

SENSE

PRE=
STB

t

FIG. 3

8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5959878 A

- DE 19832994